# EUROPÄISCHE PATENTANMELDUNG

(11) **EP 1 946 875 A1**
(43) Veröffentlichungstag der Anmeldung: **23.07.2008**
(21) Anmeldenummer: 07005179.2
(22) Anmeldetag: 13.03.2007
(51) Int. Cl.: B23K 1/08, B23K 3/06, H05K 3/34, B23K 101/42

(54) **Vorrichtung und Verfahren zum Selektivlöten**

(30) Priorität: 18.01.2007 DE 10702777
(71) Anmelder: Linde Aktiengesellschaft, 80807 München (DE); EPM Handels GmbH, 8954 Geroldswill (CH)
(72) Erfinder: Isler, Hans, 5454 Bellikon (CH); Wandke, Ernst, Dr., 82538 Geretsried (DE)

(57) **Zusammenfassung**

Die Erfindung betrifft eine Vorrichtung zum Selektivlöten aufweisend einen Behälter (10) für flüssiges Lot, der ein sog. Lotbad (9) enthält, mit einem Lotkanal (2) und mindestens einer auf den Lotkanal (2) aufgesetzten Düse (4) und einer Lotpumpe zum unter Druck Setzen von flüssigem Lot (1) im Lotkanal (2), dadurch gekennzeichnet, dass der Lotkanal (2) von einer vertikal bewegbaren Haube (5) umgeben ist, die in das Lotbad (9) eintaucht oder anderweitig zur Oberfläche des Lotbades (9) abgedichtet ist und die für jede Düse (4) einen Durchbruch (7) aufweist, und mindestens eine Eintragsvorrichtung (6) für Schutz- und/oder Aktivgas unter der Haube (5) vorgesehen ist. Des Weiteren betrifft die Erfindung ein Verfahren zum Selektivlöten.

## Beschreibung

Die vorliegende Erfindung betrifft eine Vorrichtung zum Selektivlöten aufweisend einen Behälter für flüssiges Lot, der ein sog. Lotbad enthält, mit einem Lotkanal und mindestens einer auf den Lotkanal aufgesetzten Düse und einer Lotpumpe zum unter Druck Setzen von flüssigem Lot im Lotkanal. Des Weiteren betrifft die vorliegende Erfindung ein Verfahren zum Selektivlöten.

Das Selektivlöten ist ein zum Löten von Elektronikbaugruppen etabliertes Verfahren. Besonders für große und schwere Bauelemente wie Trafos, Stecker, ELKOS und andere, die z.B. einer hohen mechanischen Belastung ausgesetzt sein können, hat es sich als vorteilhaft erwiesen. Solche Bauelemente werden bevorzugt nach der sog. Durchstecktechnik im Selektivlötverfahren gelötet. Das Selektivlötverfahren kann als örtlich begrenztes Lötverfahren beschrieben werden, bei dem das flüssige Lot meist über senkrechte Düsen den Lötstellen zugeführt wird. Zu diesem Zweck kann am oberen Ende der Düsen auch eine Mini-Lötwelle erzeugt werden. In der Druckschrift DE 43 14 241 C2 ist eine Vorrichtung zum Selektivlöten mit den vorstehend beschriebenen Eigenschaften offenbart.

Im Stand der Technik muss das Freiliegen von Lot an den oberen Enden der Düsen, vor allem in den Pausen zwischen zwei Lötvorgängen, also im Stand-by-Modus einer Selektivlötanlage als nachteilig betrachtet werden. Ebenso sind die relativ geringe Inertisierung während des Lötprozesses und eine damit verbundene verstärkte Krätzebildung sowie eine erhöhte Fehlerrate als Nachteile zu nennen.

Aufgabe der vorliegenden Erfindung ist es, eine verbesserte Vorrichtung und ein verbessertes Verfahren zum Selektivlöten zur Verfügung zu stellen.

Vorrichtungsseitig wird die gestellte Aufgabe dadurch gelöst, dass der Lotkanal von einer vertikal bewegbaren Haube umgeben ist, die in das Lotbad eintaucht oder anderweitig zur Oberfläche des Lotbades abgedichtet ist und die für jede Düse einen Durchbruch aufweist, und mindestens eine Eintragsvorrichtung für Schutz- und/oder Aktivgas unter der Haube vorgesehen ist.

Aufgrund der geringen Dimensionen und der begrenzten Lotmenge, die zum Einsatz kommt, ist der Einsatz von Schutz- und/oder Aktivgas für einen problemlosen Betrieb der Vorrichtung besonders wichtig. In der Regel wird ein inertes Schutzgas vorteilhaft sein. In besonderen Fällen kann ein Aktivgas besonderen Vorteil bringen. Im Folgenden wird nur noch der Begriff Schutzgas oder Schutzgasatmosphäre verwendet, wobei immer auch ein Aktivgas oder eine Aktivgasatmosphäre von diesem Begriff mit umfasst sein soll.

Die erfindungsgemäße Haube ermöglicht ein Einhüllen der oberen Enden der Düsen in die Schutzgasatmosphäre, wodurch der Verschmutzungsgrad der Lötstellen und die Fehlerquote beim Löten vorteilhaft gesenkt werden kann.

Es stellt einen besonderen Vorteil dar, dass die Haube als Schutzgasabdeckung in senkrechter Richtung verschiebbar angeordnet ist und somit im Stand-by-Modus, also zwischen zwei Lötvorgängen, die Düsen vollständig von der Schutzgasatmosphäre eingehüllt sind und im Lötprozess nur der für den direkten Kontakt mit den zu lötenden Bauteilen oberste Teil der Düse freigegeben wird und dadurch im Lötmodus-Modus nahezu ideal von Schutzgas umspült wird.

Die Eintragsvorrichtungen für Schutzgas können vorteilhaft als Gaslanzen ausgebildet sein.

Bevorzugt ist das obere Ende der Düse als Lötkopf zur Ausbildung einer Lötwelle ausgebildet.

Gemäß einer besonders vorteilhaften Weiterbildung der Erfindung sind Strömungsbleche an der Haube angebracht. Dadurch kann z.B. die inertisierende Wirkung des Schutzgases verbessert werden. Eine vorteilhafte Möglichkeit zur Anbringung der Strömungsbleche ist an der Haube und abwärts Richtung Lotbad gerichtet.

Mit besonderem Vorteil ist der obere Abschluss des Lotkanals als Deckblech ausgebildet. Das Deckblech schließt dicht mit dem Lotkanal ab und wird von den Düsen durchbrochen und fixiert diese.

Gemäß einer vorteilhaften Weiterbildung der Erfindung sind zur Abdeckung der Durchbrüche in der Haube zusätzliche Bleche vorgesehen. Mit diesen zusätzlichen Blechen kann die insgesamt erforderliche Schutzgasmenge erfolgreich weiter reduziert werden.

Verfahrensseitig wird die gestellte Aufgabe durch ein Verfahren gelöst, das folgende Schritte aufweist:
1) eine zu lötende und dafür vorbereitete Leiterplatte wird in einen Lötbereich transportiert,
2) entweder die Leiterplatte und die Haube werden zeitgleich zusammen abgesenkt und/oder die Leiterplatte wird auf einer zuvor abgesenkten Haube positioniert,
3) dann wird der Lötvorgang durchgeführt, wobei über die mindestens eine Düse Lot aus einem Lotkanal nach oben zur Lötstelle gepumpt wird und wobei während des Lötvorganges über eine Eintragsvorrichtung Schutz- und/oder Aktivgas eingebracht wird und
4) nach Beendigung des Lötvorganges die Leiterplatte den Lötbereich verlässt und die Einhausung des Lötbereichs durch Anheben der Haube wieder aufgehoben wird.

Der Begriff der vorbereiteten Leiterplatte meint hier insbesondere eine bestückte, gefluxte und in der Regel vorgewärmte Leiterplatte.

Mit besonderem Vorteil wird eine erste Menge pro Zeiteinheit an Schutz- und/oder Aktivgas während des Lötvorganges eingebracht und eine zweite Menge pro Zeiteinheit an Schutz- und/oder Aktivgas zwischen zwei Lötvorgängen eingebracht.

Besonders bevorzugt wird nach Beendigung des Lötvorganges die Menge des über die Eintragsvorrichtung eingebrachten Schutz- und/oder Aktivgases gegenüber der während dem Lötvorgang eingebrachten Menge reduziert.

Zweckmäßigerweise wird die Haube vor Beginn des Lötvorganges auf ein Niveau abgesenkt wird, das auf die unterseitige Bauteilgeometrie der Leiterplatte abgestimmt ist und etwas unter dem tiefsten Punkt der zu lötenden Baugruppe liegt.

Gemäß einer vorteilhaften Weiterbildung der Erfindung werden zwischen zwei Lötvorgängen die Durchbrüche in der Haube mit zusätzlichen Blechen abgedeckt.

Damit kann im sog. Stand-by-Modus die erforderliche Menge an Schutzgas weiter reduziert und die Inertisierungswirkung verbessert werden. Die zusätzlichen Bleche werden vorteilhaft mit der Absenkbewegung der Haube zu Beginn eines Lötvorganges entfernt, so dass die Durchbrüche während des Lötvorgangs offen sind. Erst mit der Aufwärtsbewegung der Haube nach Beendigung eines Lötvorganges werden die zusätzlichen Bleche wieder über den Durchbrüchen positioniert und diese damit verschlossen.

Die vorliegende Erfindung bietet eine ganze Reihe von Vorteilen. Im Folgenden sind exemplarisch einige davon genannt: Die Effizienz der Ausnutzung des eingesetzten Schutzgases wird verbessert, die Lötqualität wird erhöht, die Krätzebildung wird vermindert und der Wartungsaufwand und die Betriebskosten können mit der vorliegenden Erfindung gesenkt werden.

Die Erfindung sowie weitere Ausgestaltungen der Erfindung werden im Folgenden anhand der in den Figuren dargestellten Ausführungsbeispiele näher erläutert. Die Figuren zeigen:
- Figur 1: eine erfindungsgemäße Vorrichtung zum Selektivlöten,
- Figur 2: eine Weiterbildung einer erfindungsgemäßen Vorrichtung mit zusätzlichen Blechen zur Abdeckung

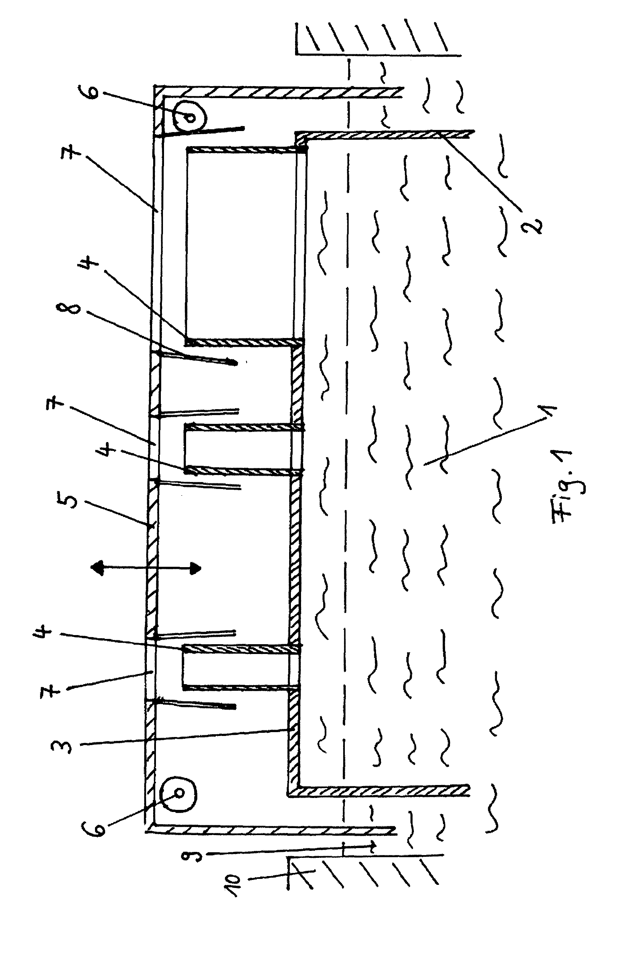

Im Einzelnen zeigt die Figur 1 einen Behälter 10 für flüssiges Lot, der ein sog. Lotbad 9 enthält, mit einem Lotkanal 2. Des Weiteren sind in der Figur drei Düsen 4 dargestellt, die auf den Lotkanal 2 aufgesetzt sind. Der Lotkanal 2 ist in diesem Beispiel und in der Regel als Druckkanal ausgebildet und zur Umgebung hin als abgeschlossen zu betrachten. In der Figur ist der Lotkanal 2 nur teilweise dargestellt.

Die Düsen 4 sind im Bereich des Deckbleches 3 auf den Lotkanal 2 aufgesetzt und werden von diesem fixiert. Um das flüssige Lot 1 unter Druck zu setzen ist eine Lotpumpe vorgesehen (nicht dargestellt). Der Lotkanal 2 ist von einer vertikal bewegbaren Haube 5 umgeben, die in das Lotbad 9 eintaucht und auf diese Weise zur Oberfläche des Lotbades 9 abgedichtet ist. Für jede Düse 4 ist in der Haube 5 ein Durchbruch 7 vorgesehen. Des Weiteren sind in diesem Beispiel zwei Eintragsvorrichtungen 6 für Schutzgas vorgesehen, die dem Einbringen von Schutzgas unter die Haube 5 dienen.

Über die Eintragsvorrichtungen 6 wird beispielsweise Stickstoff als inertisierendes Schutzgas eingeblasen. Dabei sind die Eintragsvorrichtungen 6 in diesem Beispiel als Gaslanzen 6 ausgebildet.

In einer beispielhaften Ausgestaltung des erfindungsgemäßen Verfahrens wird eine für das Selektivlöten vorbereitete Leiterplatte, nachdem sie die üblichen Funktionseinheiten wie Fluxer und Vorheizbereich passiert hat, in den Lötbereich transportiert. Unmittelbar vor der Ankunft der Leiterplatte im Lötbereich wird die Haube 5 soweit in vertikaler Richtung abgesenkt wie es in Abhängigkeit von der unterseitigen Bauteilgeometrie für einen ungestörten Selektivlötvorgang erforderlich ist. Beispielsweise wird auf ein 1 bis 2 mm unter dem tiefsten Punkt der zu lötenden Baugruppe liegendes Niveau abgesenkt. Dadurch kann eine Einsparung an Schutzgas und eine Verminderung der Krätzebildung während des Lötvorgangs erzielt werden. Die Leiterplatte wird auf der abgesenkten Haube 5 positioniert. Dann wird der Lötvorgang durchgeführt.

Nach Beendigung des Lötvorgangs wird die Haube 5 wieder in die Ausgangsstellung nach oben gefahren. Mit besonderem Vorteil wird dann nur noch mit einer gegenüber dem Lötvorgang verminderten Menge an Schutzgas begast. Dieser Modus kann auch als Stand-by-Modus bezeichnet werden. Durch den Schutzgaseintrag unter die Haube 5 im Stand-by-Modus werden die Düsen optimal weiterhin von Schutzgas umspült, wodurch die Krätzeproduktion an den oberen Enden der Düsen minimiert wird.

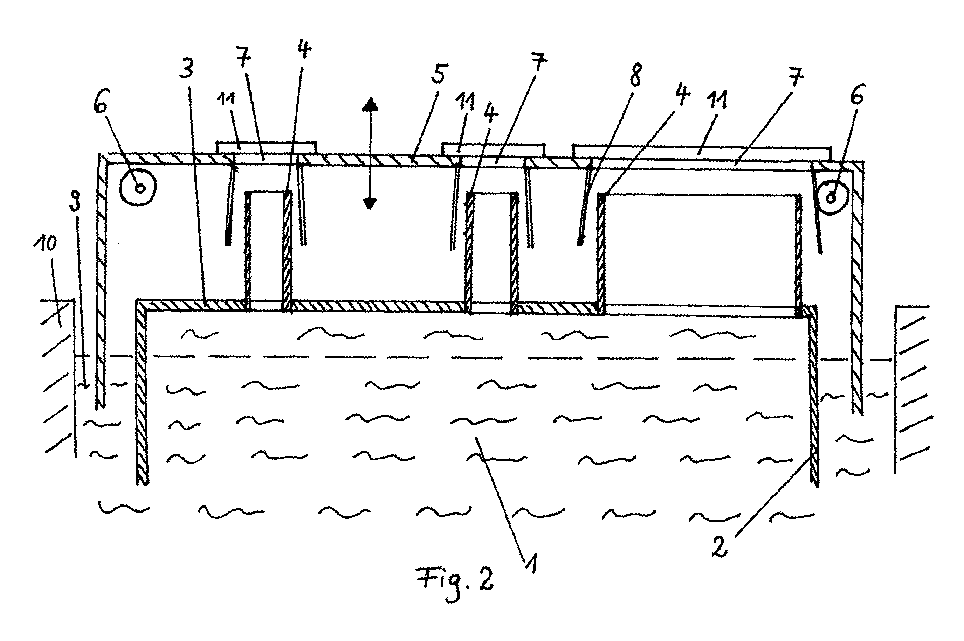

In der Figur 2 sind zusätzliche Bleche 11 gezeigt, die die Durchbrüche 7 zeitweise abdecken. Es ergibt sich ein besonderer Vorteil, wenn im Stand-by-Modus die Durchbrüche 7 in der Haube 5 mit den zusätzlichen Blechen 11 verschlossen werden, da die erforderliche Schutzgasmenge dadurch weiter reduziert und die Inertisierungswirkung verbessert werden kann. Die zusätzlichen Bleche 11 werden vorteilhaft mit der Absenkbewegung der Haube 5 zu Beginn eines Lötvorganges entfernt, so dass die Durchbrüche 7 während des Lötvorgangs offen sind. Erst mit der Aufwärtsbewegung der Haube 5 nach Beendigung eines Lötvorganges werden die zusätzlichen Bleche 11 wieder über den Durchbrüchen positioniert und diese damit verschlossen.

Durch die in der Figur 1 und in der Figur 2 gezeigten Strömungsbleche 8 kann die inertisierende Wirkung des Schutzgases weiter verbessert werden. In den vorliegenden Ausführungsbeispielen ist jedes Strömungsblech 8 als Konus geformt.

## Patentansprüche

1. Vorrichtung zum Selektivlöten aufweisend einen Behälter (10) für flüssiges Lot, der ein sog. Lotbad (9) enthält, mit einem Lotkanal (2) und mindestens einer auf den Lotkanal (2) aufgesetzten Düse (4) und einer Lotpumpe zum unter Druck Setzen von flüssigem Lot (1) im Lotkanal (2), **dadurch gekennzeichnet, dass** der Lotkanal (2) von einer vertikal bewegbaren Haube (5) umgeben ist, die in das Lotbad (9) eintaucht oder anderweitig zur Oberfläche des Lotbades (9) abgedichtet ist und die für jede Düse (4) einen Durchbruch (7) aufweist, und mindestens eine Eintragsvorrichtung (6) für Schutz- und/oder Aktivgas unter der Haube (5) vorgesehen ist.

2. Vorrichtung nach Anspruch 1, **dadurch gekennzeichnet, dass** das obere Ende der Düse (4) als Lötkopf zur Ausbildung einer Lötwelle ausgebildet ist.

3. Vorrichtung nach Anspruch 1 oder 2, **dadurch gekennzeichnet, dass** Strömungsbleche (8) an der Haube (5) angebracht sind.

4. Vorrichtung nach einem der Ansprüche 1 bis 3, **dadurch gekennzeichnet, dass** der obere Abschluss des Lotkanals (2) als Deckblech (3) ausgebildet ist.

5. Vorrichtung nach einem der Ansprüche 1 bis 4, **dadurch gekennzeichnet, dass** zur Abdeckung der Durchbrüche (7) zusätzliche Bleche (11) vorgesehen sind.

6. Verfahren zum Selektivlöten, das folgende Schritte aufweist:
1) eine zu lötende und dafür vorbereitete Leiterplatte wird in einen Lötbereich transportiert und über einer Haube (5) positioniert, wobei
2) entweder die Leiterplatte und die Haube (5) zeitgleich zusammen abgesenkt werden und/oder die Leiterplatte auf einer zuvor abgesenkten Haube (5) positioniert wird,
3) dann wird der Lötvorgang durchgeführt, wobei über die mindestens eine Düse (4) Lot aus einem Lotkanal (2) nach oben zur Lötstelle gepumpt wird und wobei während des Lötvorganges über eine Eintragsvorrichtung (6) Schutz- und/oder Aktivgas eingebracht wird und
4) nach Beendigung des Lötvorganges die Leiterplatte den Lötbereich verlässt und die Einhausung des Lötbereichs durch Anheben der Haube (5) wieder aufgehoben wird.

7. Verfahren nach Anspruch 6, **dadurch gekennzeichnet, dass** einer ersten Menge pro Zeiteinheit an Schutz- und/oder Aktivgas während des Lötvorganges eingebracht wird und eine zweite Menge pro Zeiteinheit an Schutz- und/oder Aktivgas zwischen zwei Lötvorgängen eingebracht wird.

8. Verfahren nach Anspruch 6 oder 7, **dadurch gekennzeichnet, dass** nach Beendigung des Lötvorganges die Menge des über die Eintragsvorrichtung (6) eingebrachten Schutz- und/oder Aktivgases gegenüber der während dem Lötvorgang eingebrachten Menge reduziert wird.

9. Verfahren nach einem der Ansprüche 6 bis 8, **dadurch gekennzeichnet, dass** die Haube (5) vor Beginn des Lötvorganges auf ein Niveau abgesenkt wird, das auf die unterseitige Bauteilgeometrie der Leiterplatte abgestimmt ist und etwas unter dem tiefsten Punkt der zu lötenden Baugruppe liegt.

10. Verfahren nach einem der Ansprüche 6 bis 9, **dadurch gekennzeichnet, dass** zwischen zwei Lötvorgängen die Durchbrüche (7) mit zusätzlichen Blechen (11) abgedeckt werden.
